# EUROPEAN PATENT APPLICATION

(11) **EP 1 777 433 A1**
(43) Date of publication of application: **25.04.2007**
(21) Application number: 06120541.5
(22) Date of filing: 13.09.2006
(51) Int. Cl.: F16F 1/02, H01L 41/053, F02M 47/02, F02M 63/00

(54) **Fuel injection valve**

(30) Priority: 20.10.2005 JP 2005306001
(71) Applicant: DENSO CORPORATION, Kariya-city, Aichi-pref., 448-8661 (JP)
(72) Inventor: KATO, Ichihiro, Kariya-city Aichi 448-8661 (JP); UEDA, Daiji, Kariya-city Aichi 448-8661 (JP)
(74) Representative: TBK-Patent

(57) **Abstract**

A spring member (4) for a piezoelectric type injector (1) is manufactured from a rectangular shaped sheet material, by rolling it to form as a tubular shape. Both of circumferential ends of the rolled up spring member (4) confront each other, but are not connected to each other. Multiple apertures (41) are regularly formed in a wall portion of the spring member (4). Notches (42 and 43) are formed at the confronting end portions of the spring member (4), wherein a pair of opposing notches (42, 43) form an opening, which is equivalent to the apertures (41) formed in the wall portion. A distance between the confronting end and a side end of the aperture, which is closest to the confronting end, is made to be larger than "a/2", wherein "a" is a distance between neighboring apertures (41) formed in the wall portion.

## Description

The present invention relates to a fuel injection valve of a piezoelectric type for a fuel injection apparatus.

A fuel injection valve (injector) of a piezoelectric type is used for a common rail fuel injection system for a diesel engine. A piezoelectric driving portion generally has a piezoelectric element, a piston for transmitting a displacement of the piezoelectric element, and a spring member in contact with both of the piezoelectric element and the piston for applying a preset load to the piezoelectric element. When the piezoelectric element is expanded or contracted, the piston is moved in accordance with such expansion or contraction in order to control a control valve, which controls an opening and closing of the injector.

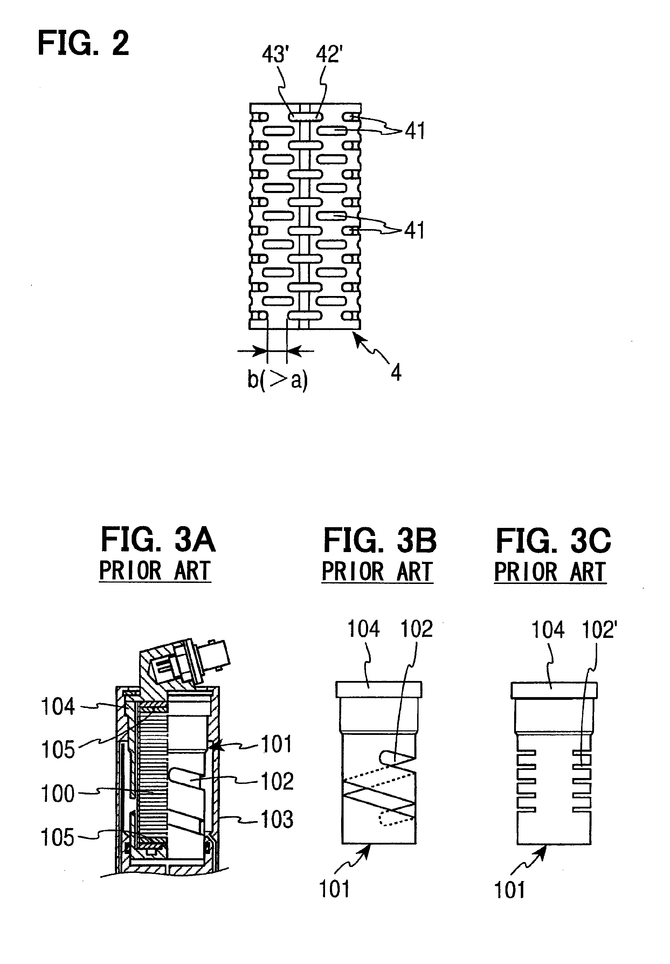

In the case that a coil spring is used as the spring member for the above injector, the piezoelectric driving portion of the injector becomes larger in size, because a volume of such coil spring itself is large. Recently, such a spring member is proposed, in which multiple apertures are formed in a tubular shaped plate member so that elasticity is given to the tubular shaped plate member. One of the examples for such spring member is disclosed in Japanese Patent Publication No. H7-94812. The spring member of this prior art is shown in Figs. 3A to 3C of this application. As shown in Figs. 3A to 3C, a spiral slit 102 or multiple slits 102' (circumferentially extending) are formed at a middle portion of a cup-shaped tubular member 101. A piezoelectric element 100 is inserted into the tubular member 101 and accommodated in a housing 103. The tubular member 101 has a large diameter portion 104 at its upper end, so that the tubular member 101 is firmly fixed to the housing 103. The piezoelectric element 100 is held in the housing 103 via insulating members 105 provided at both ends of the piezoelectric element 100.

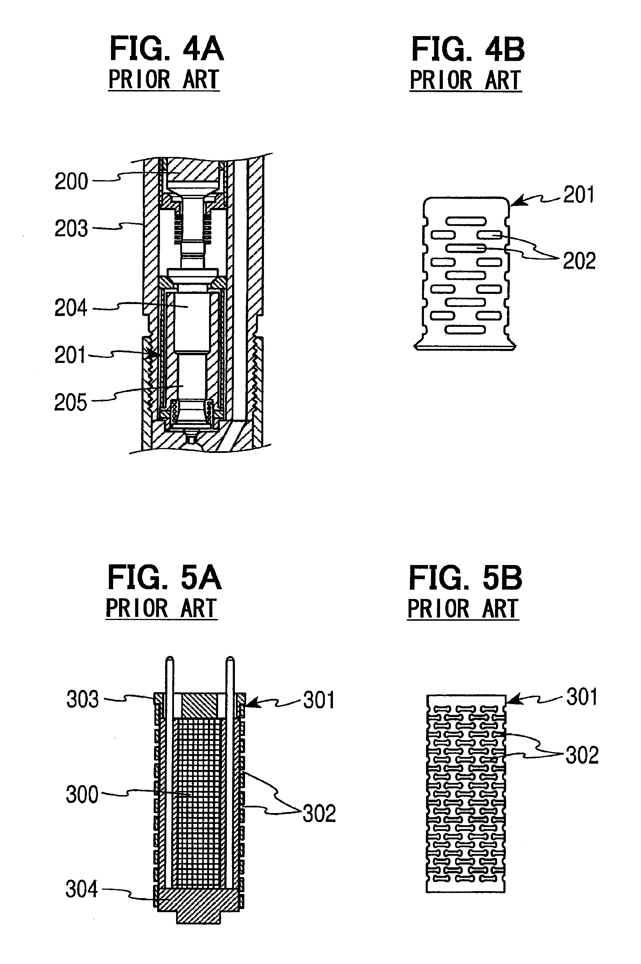

Another example for the spring member is disclosed in Japanese Patent Publication No. 2003-65179. The spring member of this prior art is shown in Figs. 4A and 4B of this application. As shown in Figs. 4A and 4B, multiple apertures 202 are formed in a cylindrical spring member 201, wherein the apertures 202 are formed by a deep-draw process and arranged at an entire surface in circumferential and longitudinal directions. The spring member 201 is disposed in a housing 203 at a lower side of a piezoelectric element 200, such that the spring member 201 surrounds pistons 204 and 205. According to the prior art, the spring member 201 has a higher circularity, because the spring member 201 is manufactured by the deep-draw process. The spring member 201 can be axially and easily assembled into the housing 203 together with other parts. It has an advantage in that a required space for the piezoelectric driving portion may become smaller.

A further example for the spring member is disclosed in International Patent Publication No. WO 00/08353. The spring member of this prior art is shown in Figs. 5A and 5B of this application. As shown in Figs. 5A and 5B, multiple bone-shaped recesses 302 are formed in a hollow member 301 in circumferential and longitudinal directions. Both of the longitudinal ends of the hollow member 301 are supported by a pair of supporting members 303 and 304, and the hollow member 301 surrounds a piezoelectric actuator 300, so that a preset compression force is applied to the piezoelectric actuator 300.

According to the above prior arts, a longitudinal length of the piezoelectric actuator can be reduced, and it can be expected that a small-sized and high-response injector is obtained and advanced fuel injection control is achieved.

However, it is not always easy to manufacture the spring member of the above prior arts. For example, the manufacturing of the spiral slit 102 for the above prior art (JP H7-94812) is complex, whereas the manufacturing of the multiple apertures 202 (or the recesses 302) for the above prior arts (JP 2003-65179, WO 00/08353) requires a step for punching the apertures and recesses by a press machine, a step for rolling up to the cylindrical shape (hollow), and a step for welding the circumferential ends. According to the prior art of JP 2003-65179, the deep-draw process is necessary to form the cylindrical member having the high circularity. As above, the manufacturing cost becomes higher.

The present invention is made in view of the foregoing problems, and has an object to provide a piezoelectric type injector for a fuel injection apparatus, wherein a spring member for the injector can be formed as a simple structure capable of applying a preset load to a piezoelectric element, and the spring member can be easily manufactured and thereby the manufacturing cost becomes lower.

According to one of features of the present invention, a fuel injection valve has a piezoelectric element (2) and a spring member (4) for applying a preset load to the piezoelectric element (2), wherein the spring member (4) is made of a rectangular sheet, which is rolled and formed into a tubular shape but circumferential confronting ends of the rolled spring member (4) are not bonded to each other.

Multiple apertures (41), which are circumferentially elongated, are formed in a wall portion of the spring member (4), such that the apertures (41) are regularly arranged in circumferential and longitudinal directions of the spring member (4), the apertures (41) are arranged at equal intervals "a" inmultiple circumferential lines, and the circumferential lines are arranged at equal intervals in the longitudinal direction.

And a distance between the circumferential confronting end and a circumferential side end of the aperture (41), which is closest to the circumferential confronting end, is larger than "a/2".

According to another feature of the present invention, a fuel injection valve has a piezoelectric element (2) and a spring member (4) for applying a preset load to the piezoelectric element (2), wherein the spring member (4) is made of a rectangular sheet, which is rolled and formed into a tubular shape but circumferential confronting ends of the rolled spring member (4) are not bonded to each other.

Multiple apertures (41), which are circumferentially elongated, are formed in a wall portion of the spring member (4), such that the apertures (41) are regularly arranged in circumferential and longitudinal directions of the spring member (4), the apertures (41) are arranged at equal intervals "a" inmultiple circumferential lines, and the circumferential lines are arranged at equal intervals in the longitudinal direction. Multiple notches (42, 43) are formed at both circumferential end portions of the spring member (4), such that the notches (42, 43) are circumferentially opposing to each other to form multiple openings.

And a distance "b" between the notch (42, 43) and the neighboring aperture (41), which is arranged in the same circumferential line, is larger than the interval "a" between the neighboring apertures (41).

The above and other objects, features and advantages of the present invention will become more apparent from the following detailed description made with reference to the accompanying drawings. In the drawings:
Fig. 1A is a schematic cross sectional view showing a fuel injection valve according to a first embodiment of the present invention;
Fig. 1B is a partial perspective view showing a spring member;
Fig. 1C is a side view showing an entire structure of the spring member;
Fig. 2 is a side view showing an entire structure of a spring member according to a second embodiment;
Fig. 3A is a schematic cross sectional view showing a main part of a conventional fuel injection valve;
Figs. 3B and 3C are side views respectively showing an entire structure of a spring member of the conventional fuel injection valve of Fig. 3A;
Fig. 4A is a schematic cross sectional view showing a main part of another conventional fuel injection valve;
Fig. 4B is a side view showing an entire structure of a spring member of the conventional fuel injection valve of Fig. 4A;
Fig. 5A is a schematic cross sectional view showing a main part of a further conventional fuel injection valve; and
Fig. 5B is a side view showing an entire structure of a spring member of the conventional fuel injection valve of Fig. 5A.

### (First Embodiment)

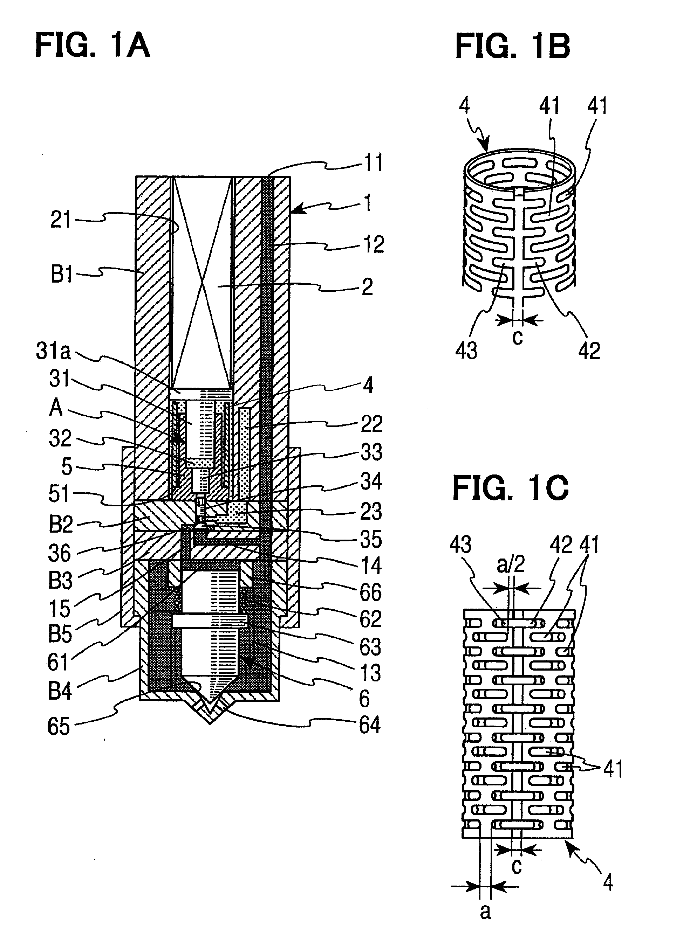

A first embodiment of the present inventionwill be explained with reference to Figs. 1A to 1C. In this embodiment, the invention is applied to a fuel injection valve of a common rail fuel injection system for a diesel engine.

Fig. 1A shows a structure of the fuel injection valve 1 (hereinafter also referred to as an injector), which is mounted to respective engine cylinders. The injector 1 is connected to a common rail (not shown), so that a high pressure fuel (diesel oil) is supplied from the common rail to the respective injectors 1. The fuel is pressurized by a supply pump (not shown) and supplied to the common rail, so that such pressurized high pressure fuel is stored in the common rail, wherein the high pressure of the fuel in the common rail is controlled at a predetermined value in order that the injector 1 injects the fuel at such predetermined high pressure.

In Fig. 1A, the injector 1 has multiple body members B1 to B4, wherein a piezoelectric element 2 and first and second pistons 31 and 33 are accommodated in the body member B1, a ball valve (a control valve) 35 is accommodated in the body members B2 and B3, and a needle 6 is accommodated in the body member B4. The body members B1 to B4 are assembled (built up) in a longitudinal direction and fluid tightly fastened to each other by a retainer B5. The injectors 1 are mounted to the respective engine cylinders such that the injector 1 is exposed to a combustion chamber of the engine.

A high pressure fuel passage 12 is formed in the body members B1 to B3 (longitudinally extending through the body members B1 to B3) to supply the high pressure fuel from the common rail (not shown) into the injector 1. The injector 1 is connected to the common rail at an inlet port 11 formed at one end (an upper end) of the high pressure fuel passage 12, and the other end of the high pressure fuel passage 12 is communicated with a fuel storing chamber 13 formed in the body member B4. A low pressure fuel passage 22 is formed in the body member B1 adjacent to the high pressure fuel passage 12. The low pressure fuel passage 22 works as a return passage, and connected to a fuel tank (not shown) provided outside of the injector 1 through an outlet port (not shown) formed in the injector 1.

The piezoelectric element 2 and the first and second pistons 31 and 33 are accommodated in a longitudinal cylindrical bore 21 formed in the body member B1, wherein the piezoelectric element 2 and the first and second pistons 31 and 33 constitute a piezoelectric driving portion. A lower end portion of the cylindrical bore 21 and a lower end portion of the low pressure fuel passage 22 are communicated with each other through a low pressure fuel path 23 formed in the body member B2. The piezoelectric element 2 is formed as a piezoelectric stack, in which multiple piezoelectric ceramics (PZT) and multiple layers of electrodes are alternately laminated. The piezoelectric element 2 expands and contracts in a laminated direction, when electric current is supplied or cut off by a driving circuit (not shown). The first and second pistons 31 and 33 are slidably held by a cylinder member 5, and an oil-tight chamber 32 is formed in the cylinder member 5 between the first and second pistons 31 and 33. The first and second pistons 31 and 33, the oil-tight chamber 32, and the cylinder member 5 constitute a displacement transmitting portion A (also referred to as a piston device and described below more in detail).

A driving force of the piezoelectric element 2 is transmitted to the ball valve 35 through the displacement transmitting portion A and a sliding pin 34. The sliding pin 34 is slidably accommodated in a cylindrical bore formed in the body member B2. A large diameter bore portion is formed at a lower side of the body member B2, in which the bore portion is communicated with the cylindrical bore of the body member B2 to constitute a valve chamber 36. The ball valve 35 is accommodated in the valve chamber 36. The ball valve 35 is formed as a semispherical shape or one unit member having a semispherical head portion and a flat bottom portion, wherein an upper top surface of the semispherical portion is in contact with the sliding pin 34. The sliding pin 34 has a small diameter pin portion at its lower side, so that an annular fluid space is formed in the cylindrical bore of the body member B2 and around the small diameter pin portion. The annular fluid space is communicated with the low pressure fuel path 23 through an orifice. A high pressure fuel path 14 is formed in the body member B3, such that one end of the path 14 is communicated with the high pressure fuel passage 12, whereas the other end of the path 14 is opened to the valve chamber 36 and opposed to a bottom flat surface of the ball valve 35.

A needle 6 is slidably accommodated in the body member B4. Fuel injection ports 64 are formed at a lower end of the body valve B4, wherein the fuel injection ports 64 pass through a wall of a sack chamber. When the sliding pin 34 drives the ball valve 35 (to move in a downward direction), the needle 6 is lifted up to open the fuel injection ports 64. An inner space of the body member B4 constitutes the fuel storing chamber 13. When the needle 6 is held at its lowermost position, a forward end (a circular conic end) of the needle 6 is seated on a nozzle seat 65, which is formed at a boundary area between the fuel storing chamber 13 and the sack chamber. Therefore, the fuel supply from the fuel storing chamber 13 to the fuel injection ports 64 is cut off. When the needle 6 is lifted up, the forward end of the needle 6 is separated from the nozzle seat 65 to inject the fuel.

A control chamber 61 is formed at an upper end of the needle 6. The valve chamber 36 is always communicated with the control chamber 61 through a communication path 15 formed in the body member B3 (passing through the body member B3). A tubular portion 66 is formed at an upper portion of the body member B4, and an upper portion of the needle 6 is slidably held by an inner surface of the tubular portion 66, to form the control chamber 61 by the upper end of the needle 6 and the inner wall of the tubular portion 66. A back pressure for the needle 6 is generated in the control chamber 61 by supplying the high pressure fuel from the high pressure fuel passage 12 through the valve chamber 36 and the communication path 15. The back pressure acts on the needle 6 in a downward direction, and biases the needle 6 together with a spring 62 in a valve closing direction. The spring 62 is disposed between a lower end of the tubular portion 66 and a flanged portion 63, which is formed at a middle portion of the needle 6. The high pressure of the fuel in the fuel storing chamber 13 acts on the circular conical surface of the forward end of the needle 6 in an upward direction (in a valve opening direction).

The ball valve 35 forms a three way valve structure, so that the fuel pressure in the control chamber 61 communicated with the valve chamber 36 is controlled by selectively changing seated position of the ball valve 35. When the ball valve 35 is held at its uppermost position, the semispherical surface of the ball valve 35 closes an opening portion of the valve chamber 36 (formed at an upper side of the valve chamber 36), so that the communication between the valve chamber 36 and the annular fluid space around the small diameter pin portion is cut off. On the other hand, when the ball valve 35 is held at its lowermost position, the bottom flat surface of the ball valve 35 closes another opening portion of the valve chamber 36 (formed at a lower side of the valve chamber 36), so that the communication between the valve chamber 36 and the high pressure fuel path 14 is cut off. In accordance with the above position of the ball valve 35, the fuel pressure in the control chamber 61 communicated with the valve chamber 36, namely the back pressure for the needle 6, is increased or decreased.

A reason for the semispherical shape for the ball valve 35 is to prevent an improper seating of the ball valve 35 with respect to the valve seats, due to a displacement of the body members B2 and B3. Namely, one of the valve seats (the other opening portion of the valve chamber 36 formed at the lower side of the valve chamber 36) as well as the seating portion of the valve 35 is formed as a flat seat surface, so that any displacement between the body members B2 and B3 can be absorbed. In addition, the ball valve 35 of the semispherical shape can be easily manufactured.

When no electric current is supplied to the piezoelectric element 2, the ball valve 35 is held at its uppermost position by a biasing force (in the upward direction) of a spring provided in the high pressure fuel path and the fuel pressure therein. In this case, the fuel pressure in the control chamber 61 communicated with the high pressure fuel path 14 through the valve chamber 36 is increased, and the needle 6 is thereby held at its valve closing position.

The displacement transmitting portion (the piston device) A will be explained. The cylinder member 5, which is accommodated in a lower portion of the cylindrical bore 21, has a large diameter cylindrical space (a first cylindrical space) at its upper side and a small diameter cylindrical space (a second cylindrical space) at its lower side. The first piston (piezo-piston) 31 is slidably held in the large diameter cylindrical space, and the second piston (valve-piston) 33 is slidably held in the small diameter cylindrical space, wherein the first piston 31 has a larger diameter than the second piston 33. A space formed between the first and second pistons 31 and 33 constitutes the oil-tight chamber 32, into which working fluid is filled. Accordingly, the displacement of the first piston 31 is converted into fluid pressure, and transmitted to the second piston 33, wherein the displacement transmitted to the second piston 33 is increased depending on a cross-sectional area ratio between the first and second pistons 31 and 33.

A flanged portion 31a is formed at an upper end of the first piston 31, wherein the flanged portion 31a is formed outside of the cylinder member 5 and in contact with directly or indirectly with a lower end of the piezoelectric element 2. The valve piston (the second piston) 33 is in contact with an upper end of the sliding pin 34 via a projected portion formed at a lower end of the second piston 33. The cylinder member 5 has a flanged portion 51 at its lower end. A spring member 4 is disposed between the flanged portion 31a of the first piston 31 and the flanged portion 51 of the cylinder member 5. The spring member 4 is formed into a tubular shape, and arranged in a space between an outer peripheral surface of the cylinder member 5 and an inner peripheral surface of the cylindrical bore 21, wherein the spring member 4 is separated from the respective peripheral surfaces with a certain clearance. The spring member 4 applies a preset spring force to the piezoelectric element 2, namely the spring member 4 urges the first piston 31 toward the piezoelectric element 2 so that the first piston 31 moves together with the piezoelectric element 2.

As shown in Figs. 1B and 1C, the spring member 4 is formed into the tubular shape by rolling a rectangular shaped sheet material. Both rolled-up circumferential ends of the spring member 4 are not connected to each other, but confront with a circumferential clearance c. In other words, the spring member 4 is formed into not a complete circular shape but a C-shape in its cross section. Multiple apertures 41 are formed in a tubular wall of the spring member 4, wherein the apertures 41 are arranged regularly at equal intervals "a" in a circumferential direction and at other equal intervals in a longitudinal direction. The apertures 41 give the spring member 4 a spring elasticity. The apertures 41 are formed as long apertures elongated in the circumferential direction, and arranged in the circumferential direction with the constant distance "a" between the respective neighboring apertures 41. The apertures 41 are arranged in the longitudinal direction at constant distances, but circumferentially displaced from the apertures 41 in the neighboring lines. The apertures 41 are, therefore, arranged such that the apertures 41 are alternately aligned in the longitudinal direction. As above, the apertures 41 are arranged in a zig-zag form, so that it has an advantage in that a spring constant is decreased.

Multiple notches 42 and 43 are formed at circumferential ends of the spring member 4, which are confronting each other. The notches 42 and 43 are symmetrically shaped and opposing to each other with the clearance "c". A pair of the notches 42 and 43 forms a long opening in combination (including the clearance "c"), which is equivalent to the aperture 41. A circumferential distance between the notch 42 and the aperture 41, or between the notch 43 and the aperture 41 in the same line is equal to the distance "a" between the neighboring apertures 41. As above, multiple apertures 41 as well as the long openings formed by the notches 42 and 43 are arranged on the entire tubular wall of the spring member 4, wherein the apertures are regularly arranged both in the longitudinal direction and the circumferential direction. As a result, stress to be generated at notches 42 and 43 of the confronting ends can be reduced, and a total balance can be maintained. Furthermore, a slant of the spring member 4 can be prevented, and the preset spring force can be equally applied to the piezoelectric element 2.

A circumferential distance between the circumferential end of the spring member 4 and a side end of the long aperture 41, which is closest to the circumferential end, is preferably selected to be larger than "a/2" (but less than "a"), in order that a desired strength is assured at the confronting circumferential ends of the spring member 4. In the case that the above circumferential distance was designed to be less than "a/2", the stress at the confronting end becomes larger than that at other portions, and it would be possible that a damage would occur at such notched portions 42 and 43.

In view of preventing the slant of the spring member 4, the clearance between the spring member 4 and the inner peripheral surface of the cylindrical bore 21 as well as the clearance between the spring member 4 and the outer peripheral surface of the cylinder member 5 is preferably designed to be as smaller as possible, for example, less than 5µm, and yielding strength of the material for the spring member 4 is preferably designed to be higher, for example, higher than 1,500 N/mm².

The spring member 4 is, for example, manufactured in the following manner. At first, a sheet material is cut to form a predetermined rectangular shape, the multiple apertures 41 (and notches 42 and 43) are formed by a punching process or laser processing, and the sheet material is rolled up to the tubular shape. The multiple apertures 41 and notches 42 and 43 can be alternatively formed, after the sheet material of the rectangular shape is rolled up to the tubular shape.

An operation of the injector 1 will be explained. In Fig. 1A, when the piezoelectric element 2 is in its discharged condition and thereby in its contracted condition, the ball valve 35 is held at its uppermost position. Therefore, the needle 6 is kept in its closed condition by the fuel pressure in the control chamber 61 as well as the spring force of the spring 62. When the electric current is supplied to the piezoelectric element 2, the piezoelectric element 2 is charged with electric energy and thereby expanded. The first piston 31 is moved in the downward direction in accordance with the expansion of the piezoelectric element 2, to compress the working fluid (diesel oil) in the oil-tight chamber 32. Then, the fluid pressure in the oil-tight chamber 32 pushes the second piston 33 and the sliding pin 34 in the downward direction, so that the ball valve 35 is downwardly moved to close the high pressure fuel path 14.

The control chamber 61 is thereby communicated to the low pressure fuel passage 22 through the communication path 15, the valve chamber 36, and the low pressure fuel path 23. When the fuel pressure in the control chamber 61 is decreased, and the biasing force acting on the needle 6 in the upward direction becomes larger than that in the downward direction, the needle 6 is lifted up from the nozzle seat 65 to inject the fuel through the fuel injection ports 64. When the piezoelectric element 2 is discharged thereafter to contract the same, the pushing force for pushing the ball valve 35 in the downward direction is removed, and thereby the ball valve 35 returns to its uppermost position. As a result, the fuel pressure in the control chamber 61 is increased again, and the needle 6 is seated on the nozzle seat 65 to stop the fuel injection.

According to the above embodiment, the spring member 4 of the displacement transmitting portion A is formed into the tubular shape, wherein the circumferential confronting ends are not connected (bonded) to each other. Therefore, a bonding process can be omitted to simplify a manufacturing process and to reduce the manufacturing cost.

Furthermore, the symmetric notches 42 and 43 are formed at the confronting end portions, so that the opening is formed by the pair of notches 42 and 43, wherein the opening is equivalent to the aperture 41. As a result, multiple apertures as well as openings can be formed on the entire portion of the tubular wall, wherein the apertures and openings are regularly arranged. The clearance between the confronting ends of the spring member 4 is designed to be as small as possible, so that the strength of the confronting end portions can be increased. Accordingly, the spring member 4 applies a desired preset load to the piezoelectric element 2 with a simple structure having the clearance c.

In addition, since the spring member 4 is arranged in the space around the outer peripheral surface of the cylinder member 5, a large space for the spring member 4 is not necessary. Since the spring member 4 is further arranged between the first piston 31 and the cylinder member 5, and both longitudinal ends of the spring member 4 are respectively in contact with the first piston 31 and the cylinder member 5, the driving force of the piezoelectric element 2 can be effectively transmitted to the first piston 31.

As a result, the injector 1, which is smaller in size and has a high performance, can be manufactured at the lower cost.

Fig. 2 shows a second embodiment of the present invention, wherein a modification of the spring member 4 is indicated. The basic structure and operation of the injector 1 are the same to those in the first embodiment.

As shown in Fig. 2, notches 42' and 43' are formed at the circumferential confronting ends of the spring member 4, as in the same manner to the first embodiment. However, in this embodiment, a distance "b" between the notch 43' and the neighboring aperture 41 in the same line is made larger than the distance "a" between the apertures 41 (b > a). This (b > a) is also applied to a distance "b" between the notch 42' and the neighboring aperture 41 in the same line. Accordingly, a circumferential length of the notches 42' and 43' is made smaller than that of the notches 42 and 43 of the first embodiment.

According to this embodiment, a spring constant at the confronting end portions is increased, and a deformation of this portion is less likely to occur against the stress generated in this portion. As a result, an inclination or a slant of the spring member 4 to the opening portion (confronting portion) is more surely suppressed.

In the above embodiment (Fig. 1A), the displacement transmitting portion A is composed of the large diameter first piston 31 and the small diameter second piston 33, so that the displacement amount to be transmitted is enlarged. However, the same diameter may be applied to the first and second pistons 31 and 33. A thermal expansion coefficient of the piezoelectric ceramics is different from that of the metal material. In the case that the oil-tight chamber 32 is arranged between the first and second pistons 31 and 33 such that the fuel is allowed to flow into and flow out from the oil-tight chamber 32, a more appropriate transmitting performance is obtained by absorbing different thermal deformation amounts among the parts having the different thermal expansion coefficients.

A two way valve structure may be applied to the injector in place of the ball valve 35 having the three way valve structure, wherein the valve chamber 36 and the low pressure fuel path is communicated or such communication is cut off by the two way valve.

A spring member (4) for a piezoelectric type injector (1) is manufactured from a rectangular shaped sheet material, by rolling it to form as a tubular shape. Both of circumferential ends of the rolled up spring member (4) confront each other, but are not connected to each other. Multiple apertures (41) are regularly formed in a wall portion of the spring member (4). Notches (42 and 43) are formed at the confronting end portions of the spring member (4), wherein a pair of opposing notches (42, 43) form an opening, which is equivalent to the apertures (41) formed in the wall portion. A distance between the confronting end and a side end of the aperture, which is closest to the confronting end, is made to be larger than "a/2", wherein "a" is a distance between neighboring apertures (41) formed in the wall portion.

## Claims

1. A fuel injection valve comprising:
a piezoelectric element (2); and
a spring member (4) for applying a preset load to the piezoelectric element (2),
wherein the spring member (4) is made of a rectangular sheet, which is rolled and formed into a tubular shape,
circumferential confronting ends of the rolled spring member (4) are not bonded to each other,
multiple apertures (41), which are circumferentially elongated, are formed in a wall portion of the spring member (4), such that the apertures (41) are regularly arranged in circumferential and longitudinal directions of the spring member (4), the apertures (41) are arranged at equal intervals "a" inmultiple circumferential lines, and the circumferential lines are arranged at equal intervals in the longitudinal direction, and
a distance between the circumferential confronting end and a circumferential side end of the aperture (41), which is closest to the circumferential confronting end, is larger than "a/2".

2. A fuel injection valve according to claim 1, wherein
multiple notches (42, 43) are formed at both circumferential end portions of the spring member (4), and
the notches (42, 43) are circumferentially opposing to each other to formmultiple openings, which are equivalent to the apertures (41).

3. A fuel injection valve according to claim 1, wherein
the spring member (4), which is formed into the tubular shape, has a C-shape in its cross section, such that the circumferential confronting ends oppose to each other with a small clearance between them.

4. A fuel injection valve according to claim 1, wherein
circumferential positions of the apertures (41) in the circumferential lines are alternately displaced from the apertures (41) in the neighboring circumferential lines.

5. A fuel injection valve according to claim 1, wherein
the distance between the circumferential confronting end and the circumferential side end of the aperture (41), which is closest to the circumferential confronting end, is larger than "a/2", but less than the interval "a".

6. A fuel injection valve according to claim 1, wherein
a distance "b" between the notch (42, 43) and the neighboring aperture (41), which is arranged in the same circumferential line, is larger than the interval "a" between the neighboring apertures (41).

7. A fuel injection valve according to claim 1, further comprising:
a piston device (5, 31, 32, 33) for transmitting a displacement of the piezoelectric element (2), wherein the spring member (4) is disposed at an outer peripheral space of the piston device (5, 31, 32, 33); and
supporting members (31a, 51) for supporting the spring member (4) in the longitudinal direction, so that the preset load is applied to the piezoelectric element (2).

8. A fuel injection valve according to claim 7, wherein
the piston device (5, 31, 32, 33) comprises;
a first piston (31) to be displaced together with the piezoelectric element (2);
a second piston (33), to which the displacement of the first piston (31) is transmitted via an oil-tight chamber (32); and
a flanged portion (31a) formed, as one of the supportingmembers, at an end of the first piston (31) on a side of the piezoelectric element (2), for supporting one end of the spring member (4).

9. A fuel injection valve according to claim 8, wherein
the piston device (5, 31, 32, 33) further comprises;
a cylinder member (5) having a first cylindrical space for slidably accommodating the first piston (31) and a second cylindrical space for slidably accommodating the second piston (33); and
a flanged portion (51) formed, as one of the supporting members, at an end of the second piston (33) on a side opposite to the piezoelectric element (2), for supporting the other end of the spring member (4).

10. A fuel injection valve according to claim 7, further comprising:
a control valve (35) to be driven by the piston device (5, 31, 32, 33) to control fuel injection from a common rail of a fuel injection apparatus.

11. A fuel injection valve comprising:
a piezoelectric element (2); and
a spring member (4) for applying a preset load to the piezoelectric element (2),
wherein the spring member (4) is made of a rectangular sheet, which is rolled and formed into a tubular shape,
circumferential confronting ends of the rolled spring member (4) are not bonded to each other,
multiple apertures (41), which are circumferentially elongated, are formed in a wall portion of the spring member (4),
multiple notches (42, 43) are formed at both circumferential end portions of the spring member (4), such that the notches (42, 43) are circumferentially opposing to each other to form multiple openings,
the multiple apertures (41) are regularly arranged in circumferential and longitudinal directions of the spring member (4) in such a manner that the multiple apertures (41) are arranged at equal intervals "a" in multiple circumferential lines, and the circumferential lines are arranged at equal intervals in the longitudinal direction, and
a distance "b" between the notch (42, 43) and the neighboring aperture (41), which is arranged in the same circumferential line, is larger than the interval "a" between the neighboring apertures (41).

12. A fuel injection valve according to claim 11, wherein
the spring member (4), which is formed into the tubular shape, has a C-shape in its cross section, such that the circumferential confronting ends oppose to each other with a small clearance between them.

13. A fuel injection valve according to claim 11, wherein
circumferential positions of the apertures (41) in the circumferential lines are alternately displaced from the apertures (41) in the neighboring circumferential lines.

14. A fuel injection valve according to claim 11, wherein
a distance between the circumferential confronting end and a circumferential side end of the aperture (41), which is closest to the circumferential confronting end, is larger than "a/2".

15. A fuel injection valve according to claim 14, wherein
the distance between the circumferential confronting end and the circumferential side end of the aperture (41), which is closest to the circumferential confronting end, is larger than "a/2", but less than the interval "a".

16. A fuel injection valve according to claim 11, further comprising:
a piston device (5, 31, 32, 33) for transmitting a displacement of the piezoelectric element (2), wherein the spring member (4) is disposed at an outer peripheral space of the piston device (5, 31, 32, 33); and
supporting members (31a, 51) for supporting the spring member (4) in the longitudinal direction, so that the preset load is applied to the piezoelectric element (2).

17. A fuel injection valve according to claim 16, wherein
the piston device (5, 31, 32, 33) comprises;
a first piston (31) to be displaced together with the piezoelectric element (2);
a second piston (33), to which the displacement of the first piston (31) is transmitted via an oil-tight chamber (32); and
a flanged portion (31a) formed, as one of the supporting members, at an end of the first piston (31) on a side of the piezoelectric element (2), for supporting one end of the spring member (4).

18. A fuel injection valve according to claim 17, wherein
the piston device (5, 31, 32, 33) further comprises;
a cylinder member (5) having a first cylindrical space for slidably accommodating the first piston (31) and a second cylindrical space for slidably accommodating the second piston (33); and
a flanged portion (51) formed, as one of the supporting members, at an end of the second piston (33) on a side opposite to the piezoelectric element (2), for supporting the other end of the spring member (4).

19. A fuel injection valve according to claim 16, further comprising:
a control valve (35) to be driven by the piston device (5, 31, 32, 33) to control fuel injection from a common rail of a fuel injection apparatus.
